# EUROPEAN PATENT APPLICATION

(11) **EP 4 657 096 A1**
(43) Date of publication of application: **03.12.2025**
(21) Application number: 24877415.0
(22) Date of filing: 10.09.2024
(51) Int. Cl.: G01R 31/382, G01R 31/385, G01R 31/367, G01R 31/392, G01R 31/389, G01R 31/396, G01R 31/374, G01R 19/12, G01R 19/165

(54) **BATTERY MANAGEMENT SYSTEM, BATTERY PACK, ELECTRIC VEHICLE, AND BATTERY MANAGEMENT METHOD**

(30) Priority: 10.10.2023 KR 20230134642
(71) Applicant: LG Energy Solution, Ltd., Seoul 07335 (KR)
(72) Inventor: HONG, Kyung-Sik, Daejeon 34122 (KR); KIM, Yun-Jung, Daejeon 34122 (KR); AHN, Ji-Hoon, Daejeon 34122 (KR)
(74) Representative: Goddar, Heinz J.
(86) International application number: PCT/KR2024/013680
(87) International publication number: WO 2025/079877

(57) **Abstract**

There are provided a battery management system, a battery pack, an electric vehicle and a battery management method. The battery management system according to the present disclosure includes a sensing unit configured to measure a cell voltage, a cell current, and a negative electrode resistance of a battery cell, and a control unit configured to determine a state of the battery cell based on a measured value of each of the cell voltage, the cell current and the negative electrode resistance.

## Description

### TECHNICAL FIELD

The present disclosure relates to electrical state estimation of battery cells.

The present application claims priority to Korean Patent Application No. 10-2023-0134642 filed on October 10, 2023 in the Republic of Korea, the disclosure of which is incorporated herein by reference.

### BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

Battery packs for applications requiring large capacity and high voltage, such as electric vehicles or energy storage systems, include a few tens to hundreds of battery cells connected in series. A battery management system is provided to acquire battery parameters (e.g., voltage, current, State of Charge (SOC), etc.) of each battery cell and perform various functions (e.g., balancing, cooling) to ensure reliability and safety of each battery.

Currently, various types of rechargeable battery cells are widely used, and some of them, for example, lithium iron phosphate (LFP) cells and lithium sulfur (LiS) cells have voltage plateau characteristic in parts of the entire SOC range (e.g., 5% to 70%).

The voltage plateau range may be an SOC range in which a change in Open Circuit Voltage (OCV) is equal to or less than the threshold in an SOC-OCV curve which is a dataset indicating a relationship between SOC and OCV and/or an SOC range in which a change in Closed Circuit Voltage (CCV) is equal to or less than the threshold during constant current charging or discharging.

When a battery cell has voltage plateau characteristic, the SOC-OCV curve (referred to as 'OCV map') and/or the SOC-CCV curve (referred to as 'CCV map') is useful for SOC estimation outside of the voltage plateau range, but within the voltage plateau range, even a small error in OCV or CCV may make a large difference between the actual SOC and its estimated SOC.

Accordingly, when the SOC of the battery cell lies in the voltage plateau range (SOC range having voltage plateau characteristic), it may be advantageous to determine the estimated SOC of the current cycle of the battery cell based on the current integration of the battery cell, rather than the OCV map or the CCV map.

However, during charging and discharging in an alternating manner, when the SOC of the battery cell is maintained within the voltage plateau range for a long time, errors between the actual current value and the detected current value of the battery cell may be continuously accumulated in the current integration, and the accuracy of SOC estimation declines. Additionally, in State Of Health (SOH) estimation of the battery cell, SOC is considered as a very important factor, so inaccurately estimated SOC may reduce the accuracy of SOH.

One solution to this problem is to estimate the SOC of the battery cell using the OCV map or CCV map after intentionally charging or discharging the battery cell to move the SOC of the battery cell out of the voltage plateau range. However, the above-described method has the problem that power is unnecessarily wasted due to the intentional charging or discharging of the battery cell, and it takes a longer time to estimate the SOC.

### DISCLOSURE

### Technical Problem

Through multiple experiments, the inventors recognized the fact that a battery cell has a strong correspondence relationship between State of Charge (SOC) and negative electrode resistance.

The present disclosure is designed to solve the above-described problem, and therefore the present disclosure is directed to providing a battery management system, a battery pack, an electric vehicle and a battery management method for suppressing the decline in SOC estimation accuracy caused by voltage plateau characteristic by using an SOC estimation logic (a second SOC estimation logic as described below) using the negative electrode resistance of a battery cell as the input variable.

These and other objectives and advantages of the present disclosure may be understood from the following description and will become apparent from the exemplary embodiments of the present disclosure. Also, it will be easily understood that the objectives and advantages of the present disclosure may be realized by the means set forth in the appended claims and a combination thereof.

### Technical Solution

A battery management system according to an aspect of the present disclosure includes a sensing unit configured to measure a cell voltage, a cell current, and a negative electrode resistance of a battery cell, and a control unit configured to determine a state of the battery cell based on a measured value of each of the cell voltage, the cell current and the negative electrode resistance.

The control unit may be configured to determine a first estimated state of charge (SOC) based on the measured value of each of the cell voltage and the cell current by executing a first SOC estimation logic. The control unit may be configured to determine a second estimated SOC based on the measured value of the negative electrode resistance by executing a second SOC estimation logic. The control unit may be configured to determine an estimated SOC of a current cycle of the battery cell based on at least one of the first estimated SOC or the second estimated SOC.

The control unit may be configured to determine the estimated SOC of the current cycle of the battery cell to be equal to any one of the first estimated SOC and the second estimated SOC or a weighted average of the first estimated SOC and the second estimated SOC according to a result of comparing the first estimated SOC with a voltage plateau range.

The control unit may be configured to determine the estimated SOC of the current cycle of the battery cell to be equal to the first estimated SOC when the first estimated SOC is outside of the voltage plateau range.

The control unit may be configured to determine the estimated SOC of the current cycle of the battery cell to be equal to the second estimated SOC when the first estimated SOC is inside of the voltage plateau range.

The control unit may be configured to determine a first weight associated with the first SOC estimation logic and a second weight associated with the second SOC estimation logic according to a difference between the voltage plateau range and the first estimated SOC when the first estimated SOC is outside of the voltage plateau range. The control unit may be configured to determine the estimated SOC of the current cycle of the battery cell to be equal to the weighted average of the first estimated SOC and the second estimated SOC based on the first weight and the second weight.

The first weight may have a predetermined positive correlation to the difference between the voltage plateau range and the first estimated SOC. The second weight may have a predetermined negative correlation to the difference between the voltage plateau range and the first estimated SOC.

The control unit may be configured to determine the estimated SOC of the current cycle of the battery cell to be equal to the weighted average of the first estimated SOC and the second estimated SOC based on a third weight and a fourth weight when the first estimated SOC is inside of the voltage plateau range.

The control unit may be configured to determine a first weight associated with the first SOC estimation logic and a second weight associated with the second SOC estimation logic according to a difference between the voltage plateau range and the first estimated SOC when the first estimated SOC is outside of the voltage plateau range. The control unit may be configured to determine the weight and the second weight according to a retention time of the SOC within the voltage plateau range. The third weight may have a predetermined negative correlation to the retention time. The fourth weight may have a predetermined positive correlation to the retention time.

The control unit may be configured to determine a current estimated SOH of the battery cell based on the measured value of each of the negative electrode resistance and a cell temperature of the battery cell when the estimated SOC of the current cycle indicates a fully discharged or fully charged state.

A battery pack according to another aspect of the present disclosure may include the battery management system.

An electric vehicle according to still another aspect of the present disclosure may include the battery pack.

A battery management method according to further another aspect of the present disclosure includes the steps of measuring a cell voltage, a cell current, and a negative electrode resistance of a battery cell, and determining a state of the battery cell based on a measured value of each of the cell voltage, the cell current and the negative electrode resistance.

The step of determining an electrical state of the battery cell may include the steps of determining a first estimated SOC based on the measured value of each of the cell voltage and the cell current by executing a first SOC estimation logic, determining a second estimated SOC based on the measured value of the negative electrode resistance by executing a second SOC estimation logic, and determining an estimated SOC of a current cycle of the battery cell based on at least one of the first estimated SOC or the second estimated SOC.

The step of determining the estimated SOC of the current cycle of the battery cell may include the step of determining the estimated SOC of the current cycle of the battery cell to be equal to any one of the first estimated SOC and the second estimated SOC or a weighted average of the first estimated SOC and the second estimated SOC according to a result of comparing the first estimated SOC with a voltage plateau range.

### Advantageous Effects

According to at least one of the embodiments of the present disclosure, it may be possible to suppress the decline in State of Charge (SOC) estimation accuracy caused by voltage plateau characteristic by using an additional SOC estimation logic ('the second SOC estimation logic' described below) using the negative electrode resistance of the battery cell as the input variable together with the commonly used SOC estimation logic ('the first SOC estimation logic' described below) to estimate the SOC of the battery cell.

Additionally, according to at least one of the embodiments of the present disclosure, it may be possible to improve the SOC estimation accuracy in the entire SOC range by finally determining, as the SOC of the battery cell, any one of the estimated SOC by the first SOC estimation logic and the estimated SOC by the second SOC estimation logic or their weighted average according to a difference between the estimated SOC by the first SOC estimation logic and the voltage plateau range.

Additionally, according to at least one of the embodiments of the present disclosure, it may be possible to improve the SOC estimation accuracy in the entire SOC range by determining the weight for each of the estimated SOC by the first SOC estimation logic and the estimated SOC by the second SOC estimation logic according to the retention time of the estimated SOC by the first SOC estimation logic inside or outside of the voltage plateau range, and finally determining the SOC of the battery cell to be equal to the weighted average of the two estimated SOCs by the two weights.

The effects of the present disclosure are not limited to the aforementioned effects, and these and other effects will be clearly understood by those skilled in the art from the appended claims.

### BRIEF DESCRIPTION OF THE DRAWINGS

The accompanying drawings illustrate the exemplary embodiments of the present disclosure and together with the following detailed description, serve to provide a better understanding of the technical aspect of the present disclosure, and thus the present disclosure should not be construed as being limited to the drawings.
FIG. 1 is a diagram exemplarily showing an electric vehicle including a battery management system according to the present disclosure.
FIGS. 2a to 2c are graphs referenced in describing the internal/external structure of a battery cell.
FIG. 3 is a graph exemplarily showing a State of Charge (SOC)-Open Circuit Voltage (OCV) curve of a battery cell.
FIG. 4 is a graph exemplarily showing an SOC-negative electrode resistance curve of a battery cell.
FIG. 5 is a graph referenced in describing a relationship between state of health (SOH) and SOC-negative electrode resistance curves of a battery cell.
FIG. 6 is a flowchart exemplarily showing a battery management method performed by a battery management system shown in FIG. 1.
FIG. 7 is a flowchart exemplarily showing the subroutines of the step S620 in FIG. 6.
FIG. 8 is a flowchart schematically showing an example of the subroutines of the step S730 in FIG. 7.
FIG. 9 is a flowchart schematically showing another example of the subroutines of the step S730 in FIG. 7.
FIG. 10 shows an example of a weight map that may be used when performing the method of FIG. 9.
FIG. 11 is a flowchart schematically showing another example of the subroutines of the step S730 in FIG. 7.
FIG. 12 shows an example of a first correction coefficient map used to correct a first weight.
FIG. 13 shows an example of a second correction coefficient map used to correct a fourth weight.
FIG. 14 is a flowchart exemplarily showing a battery management method according to a second embodiment of the present disclosure.

### BEST MODE

Hereinafter, the exemplary embodiments of the present disclosure will be described in detail with reference to the accompanying drawings. Prior to the description, it should be understood that the terms or words used in the specification and the appended claims should not be construed as being limited to general and dictionary meanings, and rather, may be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time the application was filed.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "control unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

In the specification, State Of Charge (SOC) refers to a ratio of the remaining capacity to the full charge capacity of an energy storage unit (for example, a battery cell, a cell group), expressed as 0% to 100%.

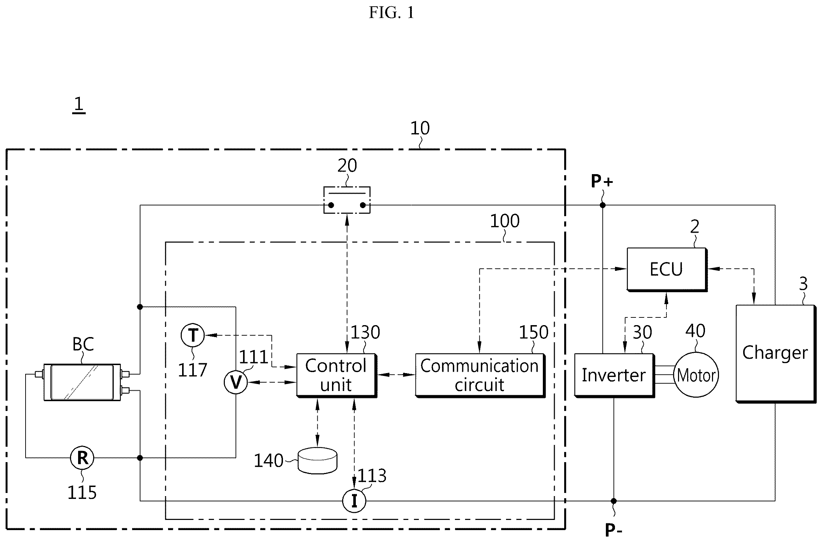

FIG. 1 is a diagram exemplarily showing an electric vehicle including a battery management system according to the present disclosure.

Referring to FIG. 1, the electric vehicle 1 includes a vehicle controller 2, a battery pack 10, an inverter 30 and a motor 40.

Charge/discharge terminal P+, P- of the battery pack 10 may be electrically coupled to the inverter 30 and/or a charger 3 through an electrical cable. The charger 3 may be included in the electric vehicle 1, or may be present in a charging station outside of the electric vehicle 1.

The vehicle controller 2 (for example, an Electronic Control Unit (ECU)) is configured to transmit a key-on signal to a battery management system 100 in response to a user's changing a starter button (not shown) of the electric vehicle 1 to an ON-position. The vehicle controller 2 is configured to transmit a key-off signal to the battery management system 100 in response to the user's changing the starter button to an OFF-position. The charger 3 may supply a charge power (for example, constant current, constant voltage, constant power) through the charge/discharge terminal P+, P- of the battery pack 10 via communication with the vehicle controller 2.

The battery pack 10 includes a battery cell BC and a relay 20, and may further include the battery management system 100.

The battery cell BC may be, for example, an energy storage device that can be repeatedly charged and discharged and has voltage plateau characteristic, such as a lithium iron phosphate (LFP) cell, a lithium sulfur (LiS) cell. The voltage plateau range is a SOC range preset or identified as a change in voltage of the battery cell BC less than the threshold.

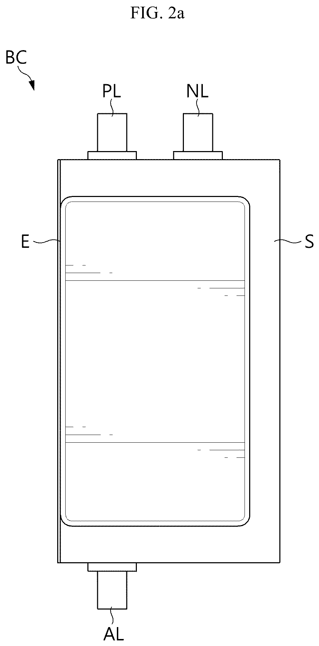

The structure of the battery cell BC will be described in further detail with reference to FIGS. 2a to 2c below.

A series circuit of the battery cell BC, a current sensor 113 and the relay 20 is electrically connected to the inverter 30 and/or the charger 3 through the charge/discharge terminal P+, P-.

The relay 20 is installed on a power path provided as a current path for the charge/discharge of the battery pack 10. While the relay 20 is turned on, power may be transferred from the battery pack 10 to the inverter 30 and/or from the charger 3 to the battery pack 10. The relay 20 may include any one of known switching devices such as a mechanical contactor or a Field Effect Transistor (FET) or a combination of two or more. A control unit 130 may control the relay 20 from one of ON-state and OFF-state to the other.

The inverter 30 is provided to convert a direct current from the battery group 11 included in the battery pack 10 to an alternating current in response to a command from the battery management system 100 or the vehicle controller 2. The motor 40 may operate using the alternating current from the inverter 30. The motor 40 may include, for example, a 3-phase alternating current motor.

The voltage across the battery cell BC may be referred to as 'cell voltage'. The state of the battery cell BC being charged/discharged by turn-on of the relay 20 may be referred to as loading (cycling). The voltage of the battery cell BC detected under load may be referred to as Closed Circuit Voltage (CCV).

When the relay 20 is shifted from ON-state to OFF-state, the battery cell BC is under no load (at rest, in calendar). The voltage across the battery cell BC under no load may be referred to as no-load voltage. The no-load voltage refers collectively to relaxation voltage and Open Circuit Voltage (OCV). Specifically, when the battery cell BC is shifted from load to no load, the polarized battery cell BC starts to depolarize spontaneously, and the no-load voltage of the battery cell BC converges to OCV. The OCV indicates the no-load voltage when the battery cell BC is kept under no load for a predetermined time (for example, 2 hours) or more, and a change in voltage of the battery cell BC is less than a predetermined value. That is, the OCV is the no-load voltage when the polarization of the battery cell BC is reduced to a negligible level. The relaxation voltage is the no-load voltage before polarization is sufficiently reduced.

The battery management system 100 is provided to monitor the condition of the battery cell BC.

The battery management system 100 includes a sensing unit 110 and the control unit 130. The battery management system 100 may further include a communication unit 150.

The sensing unit 110 includes a voltage sensor 111, the current sensor 113 and a resistance sensor 115. The sensing unit 110 may further include a temperature sensor 117.

The voltage sensor 111 is provided to be electrically connected to a positive lead and a first negative lead of the battery cell BC. The voltage sensor 111 detects the cell voltage of the battery cell BC using a change in potential between a pair of sensing lines, each connected to each of the positive lead PL and the first negative lead NL of the battery cell BC. The voltage sensor 111 may transmit a voltage signal indicating the detected cell voltage of the battery cell BC to the control unit 130 through analog-to-digital conversion.

The current sensor 113 is connected in series to the battery cell BC through the charge/discharge current path of the battery cell BC. The current sensor 113 may include one of known current sensors such as a shunt resistor or a Hall-effect device or a combination of two or more.

The current sensor 113 may be configured to generate a current signal indicating a cell current or a charge/discharge current flowing between the positive lead PL and the first negative lead NL of the battery cell BC and output it to the control unit 130.

The resistance sensor 115 may be connected between the first negative lead NL and a second negative lead AL of the battery cell BC and provided to measure the negative electrode resistance of the battery cell BC. The resistance sensor 115 may include, for example, Electrochemical Impedance Spectroscopy (EIS) equipment.

The EIS is a method that applies an alternating current (AC) voltage to an object (i.e., the battery cell), and measures the resistance of the object by analyzing a response signal to the applied AC voltage, and can analyze more precisely than the constant current or constant voltage measurement method. The amplitude of the AC voltage may range from 0.01 mV to 0.5 mV, or from 0.01 mV to 0.2 mV, or from 0.2 mV to 0.5 mV. When the amplitude of the alternating current voltage lies in the aforementioned range, it may be possible to increase the accuracy of resistance measurement and prevent damage to the battery cell BC.

In an embodiment of the present disclosure, the frequency of alternating current voltage used to measure the resistance may range from 100 Hz to 1000 Hz.

During charging/discharging of the battery cell BC, as the negative electrode of the battery cell BC expands or shrinks, the thickness of the negative electrode of the battery cell BC also changes. Specifically, during charging, as the negative electrode of the battery cell BC expands, the thickness of the negative electrode increases, and on the contrary, during discharging, as the negative electrode of the battery cell BC shrinks, the thickness of the negative electrode decreases. The resistance sensor 115 may be configured to output a resistance signal indicating the negative electrode resistance to the control unit 130 during charging/discharging of the battery cell BC.

It is known that the resistance of a conductor is inversely proportional to its thickness. Additionally, the inventors recognized the fact that the thickness of the negative electrode of the battery cell BC has a unique relationship with the SOC from a change pattern of the thickness of the negative electrode of the battery cell BC during charging/discharging. This demonstrated the fact that the negative electrode resistance of the battery cell BC is an indicator having strong reliance on the SOC of the battery cell BC.

The temperature sensor 117 may be directly attached to an outer packaging of the battery cell BC, or may be spaced a predetermined distance apart from the outer packaging of the battery cell BC. The temperature sensor 117 may be configured to output a temperature signal indicating the temperature of the battery cell BC to the control unit 130. The temperature sensor 117 may include, for example, a thermocouple.

The control unit 130 is operably coupled to the relay 20, the sensing unit 110, the memory 140 and/or the communication unit 150. The operably coupled refers to direct/indirect connection to enable signal transmission and reception in one or two directions.

The control unit 130 may be implemented in hardware using at least one of digital signal processors (DSPs), digital signal processing devices (DSPDs), programmable logic devices (PLDs), field programmable gate arrays (FPGAs), microprocessors, or electrical units for performing other functions.

The memory 140 may pre-store programs and data necessary to perform battery management methods according to the embodiments as described below. The memory may include, for example, at least one type of computer-readable storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). Although FIG. 1 shows that the memory 140 is provided independently of the control unit 130, the memory 140 may be provided in an embedded form in the control unit 130.

The control unit 130 may determine, every set time (for example, 0.01 sec), a voltage value, a current value, a temperature value and a negative electrode resistance value based on the voltage signal, the current signal, the temperature signal and the resistance signal received from the sensing unit 110 and record these values in the memory 140. Because the current signal includes current direction information, the control unit 130 may determine whether the battery cell BC is being charged or discharged or at rest based on the current signal. The rest (or resting) represents that the charge and discharge of the battery pack 10 is stopped.

The control unit 130 may determine a cumulative amount of current based on the current signal by ampere counting (current integration). The cumulative amount of current at a certain point of time refers to the total amount of current accumulated over a period of time from the time when the cumulative amount of current was initialized last before the corresponding point of time to the corresponding point of time.

The communication unit 150 may be coupled to the vehicle controller 2 of the electric vehicle 1 to enable communication with each other. The communication unit 150 may transmit a message from the vehicle controller 2 to the control unit 130, and the message from the control unit 130 to the vehicle controller 2. The message from the control unit 130 may include information for notifying an electrical state (for example, SOC, SOH) of the battery cell BC. For example, a wired network such as local area network (LAN), controller area network (CAN), or daisy chain and/or a short-range wireless network such as Bluetooth, Zigbee, or WiFi may be used for the communication between the communication unit 150 and the vehicle controller 2. The battery management system 100 may further include an output device (for example, a display, a speaker) to provide the information received by the communication unit 150 from the control unit 130 and/or the vehicle controller 2 in a recognizable form. The vehicle controller 2 may control the inverter 30 and/or the charger 3 based on the information collected via the communication with the battery management system 100.

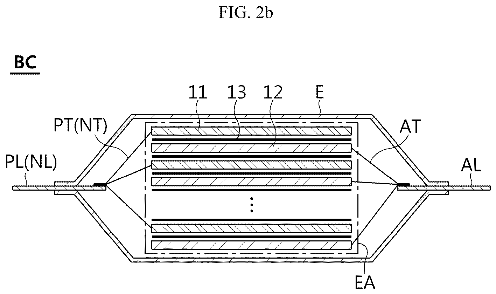

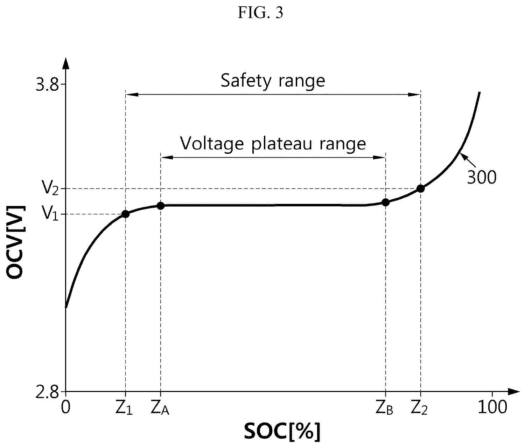

FIGS. 2a to 2c are graphs referenced in describing the internal/external structure of the battery cell. Specifically, FIG. 2a is a top view of the battery cell BC, FIG. 2b is a side cross-sectional view of the battery BC, and FIG. 3b shows the structure of a negative electrode plate 12 of the battery BC.

Referring to FIGS. 2a to 2c, the battery cell BC includes the outer packaging E and an electrode assembly EA.

The outer packaging E provides a space in which the electrode assembly EA may be housed. When the electrode assembly EA is placed in the outer packaging E, a sealing process (for example, heat bonding) is performed on the side of the outer packaging E, to complete the manufacture of the battery cell BC. The symbol S indicates the sealed side of the outer packaging E.

The electrode assembly EA includes the positive lead PL, the positive electrode plate 11, the separator 13, the first negative lead NL, the second negative lead AL, and the negative electrode plate 12. The electrode assembly EA includes at least one positive electrode plate 11, at least one negative electrode plate 12 and at least one separator 13 stacked or folded in a preset pattern. The positive electrode plate 11 and the negative electrode plate 12 are electrically insulated from each other by the separator 13.

A positive tab PT is protruded from the positive electrode plate 11 toward the positive lead PL. Likewise, a first negative tab NT and a second negative tab AT are protruded from different regions of the negative electrode plate 12 toward the first negative lead NL and the second negative lead AL, respectively. For example, the first negative tab NT is protruded in the same direction as the positive tab PT from one edge of the negative electrode plate, while the second negative tab AT is protruded in a direction opposite to the direction in which the first negative tab NT is protruded from the other edge of the negative electrode plate on the opposite side to the edge where the first negative tab NT is protruded.

One end of each of the positive tab PT, the first negative tab NT and the second negative tab AT is individually coupled to one end of each of the positive lead PL, the first negative lead NL and the second negative lead AL on the inner side of the outer packaging E, respectively. The other end of each of the positive lead PL, the first negative lead NL and the second negative lead AL is exposed to the outside of the outer packaging E.

The negative electrode plate 12 may include a lithium metal foil connected to the first negative tab NT and the second negative tab AT. The negative electrode plate 12 may only include a lithium metal foil without a current collector plate, and in this case, the lithium metal foil may be a free-standing type having responsibility for the function of the current collector plate commonly used in the art.

The other end of each of the positive lead PL and the first negative lead NL acts as a positive terminal and a negative terminal for charge/discharge of the battery cell BC, respectively. The voltage sensor 111 is connected to the positive terminal and the negative terminal of the battery cell BC to measure the cell voltage of the battery cell BC.

The other end of the second negative lead AL acts as an auxiliary terminal of the battery cell BC. The resistance sensor 115 is connected between the negative terminal NL and the auxiliary terminal AL of the battery cell BC to measure the negative electrode resistance of the battery cell BC.

As described above, the first negative tab NT and the second negative tab AT are protruded from two opposite edges of the negative electrode plate 12, and the first negative lead NL and the second negative lead AL are coupled to the first negative tab NT and the second negative tab AT, respectively.

Accordingly, compared to the structure in which the first negative tab NT and the second negative tab AT are protruded from the same edge of the negative electrode plate 12, the negative electrode resistance measured by the resistance sensor 115 may sufficiently reflect the real state of the negative electrode plate 12.

The positive electrode plate 11 includes a positive current collector and a positive electrode active material. The positive electrode active material may include a sulfur-carbon composite. The sulfur-carbon composite may include at least one of sulfur or a sulfur-based compound. Here, the sulfur-based compound may refer collectively to materials containing sulfur (S).

The sulfur-based compound may include, for example, all sulfur-containing compounds that may be formed through reduction reaction of inorganic sulfur (S8) or oxidation reaction of lithium sulfide (Li₂S), and more specifically, may include lithium sulfide (Li₂S), lithium polysulfide (Li₂Sx, an integer of 2 ≤ x ≤ 8), disulfide compounds, carbon-sulfur polymer ((C₂S_{y})ₙ, y = 2.5 to 50, n≥2), lithium sulfide (Li₂S) or two or more of them.

The positive electrode active material may be applied to at least one surface of the positive current collector. The positive current collector may include, for example, copper, stainless steel, aluminum, nickel, titanium, palladium, sintered carbon, copper or stainless steel treated with carbon, nickel or silver on the surface, or aluminum-cadmium alloys.

The loading amount of the positive electrode active material may be 1 to 2.5 time as large as the loading amount of the negative electrode active material. When the loading amount of the positive electrode active material and the negative electrode active material lies in the aforementioned range, the battery cell BC may be evaluated as having sufficient energy density and life.

The lithium metal foil of the negative electrode plate 12 may include a lithium alloy. The lithium alloy may include elements that form alloys with lithium. The elements that form alloys with lithium may include, for example, Si, Sn, C, Pt, Ir, Ni, Cu, Ti, Na, K, Rb, Cs, Fr, Be, Mg, Ca, Sr, Sb, Pb, In, Zn, Ba, Ra, Ge, or Al.

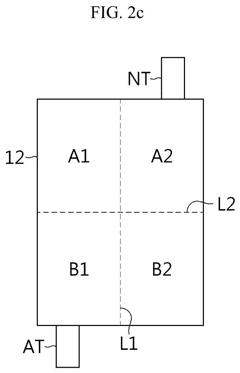

As shown in FIG. 2c, assume that the negative electrode plate 12 is approximately rectangular in shape, the negative electrode plate 12 may be divided into four regions A1, A2, B1, B2 on the basis of the center line of the negative electrode plate 12 in the width direction and the center line of the negative electrode plate 12 in the length direction.

On the basis of the center line in the length direction, the region A1 and the region B1, and the region A2 and the region B2 are in line symmetry. Additionally, the region A1 and the region B2, and the region A2 and the region B1 are in point symmetry.

The first negative tab NT and the second negative tab AT of the battery cell BC may be respectively connected to the two regions A2, B1 in point symmetry among the regions A1, A2, B1, B2 divided from the negative electrode plate 12 and protruded in the opposite directions. Accordingly, because the distance between the first negative tab NT and the second negative tab AT may be maximized, the measured negative electrode resistance by the resistance sensor 115 may accurately represent the actual negative electrode resistance.

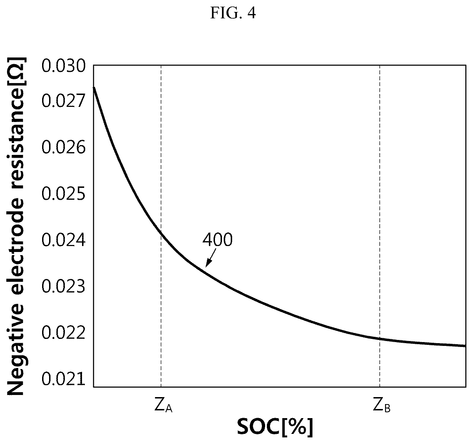

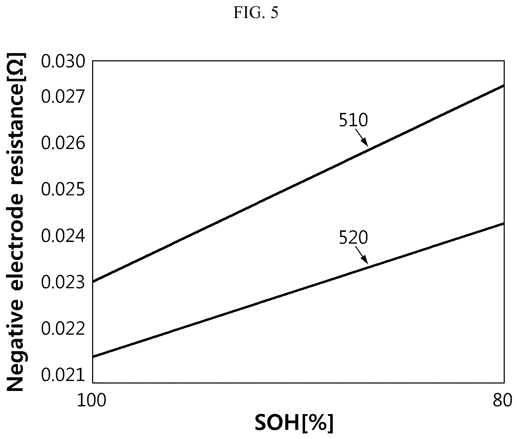

FIG. 3 is a graph exemplarily showing an SOC-OCV curve of the battery cell, FIG. 4 is a graph exemplarily showing an SOC-negative electrode resistance curve of the battery cell, and FIG. 5 is a graph referenced in describing a relationship between SOH and SOC-negative electrode resistance curves of the battery cell.

Referring to FIG. 3, the memory 140 stores first relationship data including the SOC-OCV curve 300.

The SOC-OCV curve 300 may be mapped to a specific temperature range and a specific SOH range. The SOC-OCV curve 300 records the voltage plateau range (Z_{A} ~ Z_{B}). As an example, the start SOC(Z_{A}) and the end SOC(Z_{B}) of the voltage plateau range may be 5% and 70%, respectively. For reference, the SOC-OCV curve may be simply referred to as 'OCV map'. For reference, FIG. 3 shows a single voltage plateau range Z_{A} ~ Z_{B}, but two or more voltage plateau ranges may exist depending on the electrochemical specification of the battery cell BC.

When a plurality of temperature ranges is predefined, the memory 140 may record the first relationship data prepared individually for each temperature range. The control unit 130 may acquire, from the memory 140, first relationship data associated with a single temperature range to which the temperature value (measured cell temperature) of the battery cell BC belongs among the plurality of temperature ranges, and use it to estimate the SOC.

Likewise, when a plurality of SOH ranges is predefined, the memory 140 may store the first relationship data prepared individually for each SOH range. The control unit 130 may acquire first relationship data associated with a single SOH range to which the SOH of the battery cell BC belongs among the plurality of SOH ranges from the memory 140, and use it to estimate the SOC. For reference, the SOH may be referred to as capacity retention.

For example, when the number of temperature ranges is 10, and the number of SOH ranges is 20, the total 200 first relationship data may be prestored in the memory 140, and the SOC-OCV curve 300 may be a dataset included in any one of the total 200 first relationship data.

The OCV of the battery cell BC is almost uniformly maintained over the voltage plateau range (Z_{A} ~ Z_{B}). That is, in the voltage plateau range (Z_{A} ~ Z_{B}), a change in OCV as a function of SOC (for example, a differential value) is maintained below a predetermined reference value.

In contrast, in the remaining range (0~Z_{A} %, Z_{B}~100 %) outside of the voltage plateau range (Z_{A} ~ Z_{B}), the change in OCV as a function of SOC is larger than the predetermined reference value. Accordingly, when OCV is identified, SOC corresponding to the identified OCV may be determined from the SOC-OCV curve 300 with high accuracy.

It is known that most of rechargeable batteries including the battery cell BC degrade faster when they are continuously used (charged/discharged) at or near SOC 0% or SOC 100% outside of the optimum range. A safety voltage range (V₁ ~ V₂) is preset in view of a relationship between SOC and degradation rate of the battery cell BC. SOC(Z₁) corresponding to the lower limit V₁ of the safety voltage range V₁ ~ V₂ is smaller than OCV corresponding to the start SOC(Z_{A}) of the voltage plateau range. SOC(Z₂) corresponding to the upper limit V₂ of the safety voltage range V₁ ~ V₂ is higher than the end SOC(Z_{B}) of the voltage plateau range. The SOC range Z₁ ~ Z₂ corresponding to the safety voltage range (V₁ ~ V₂) may be referred to as a safety range.

The control unit 130 may periodically estimate the SOC of the battery cell BC at each set time, and when the estimated SOC of the previous cycle is smaller than the start SOC(Z_{A}) by a set value or more or when the estimated SOC of the previous cycle is larger than the end SOC(Z_{B}) by a set value or more (for example, outside of the safety range), the resistance sensor 115 may be inactivated. That is, in obtaining the estimated SOC, in the case where there is no or little need for the SOC-negative electrode resistance curve 400 as described below, when the resistance sensor 115 is inactivated, it may be possible to save the power required to operate the resistance sensor 115 and reduce the computation load required to process the measured negative electrode resistance.

Meanwhile, during charging/discharging of the battery cell BC including a specific material (for example, lithium metal) in the electrode, intercalation or deintercalation reaction of working ions (for example, lithium ions) occurs in the grid of the electrode, causing a volume change. Accordingly, the inventors recognized the fact that the time-dependent change of negative electrode resistance of the battery cell BC detected by the resistance sensor 115 has sufficient correlation to the time-dependent change of SOC of the battery cell BC.

Referring to FIG. 4, the memory 140 stores second relationship data including the SOC-negative electrode resistance curve 400 indicating a relationship between the SOC and the negative electrode resistance of the battery cell BC. The SOC-negative electrode resistance curve 400 may be mapped to a specific temperature range and a specific SOH range. The SOC-negative electrode resistance curve may be referred to as a 'negative electrode resistance map'.

When a plurality of temperature ranges is predefined, the memory 140 may record the second relationship data prepared individually for each temperature range. The control unit 130 may acquire second relationship data associated with a single temperature range to which the temperature value of the battery cell BC belongs among the plurality of temperature ranges from the memory 140, and use it to estimate the SOC.

Likewise, when a plurality of SOH ranges is predefined, the memory 140 may record the second relationship data prepared individually for each SOH range. The control unit 130 may acquire second relationship data associated with a single SOH range in which the SOH of the battery cell BC belongs among the plurality of SOH ranges from the memory 140, and use it to estimate the SOC. For example, when the number of temperature ranges is 10 and the number of SOH ranges is 20, the total 200 second relationship data may be prestored in the memory 140, and the SOC-negative electrode resistance curve 400 may be a dataset included in any one of the total 200 second relationship data.

According to the SOC-negative electrode resistance curve 400 shown in FIG. 4, it can be seen that as the SOC of the battery cell BC increases from 0% to 100%, the negative electrode resistance of the battery cell BC gradually decreases. As opposed to the SOC-OCV curve 300 shown in FIG. 3, a change in negative electrode resistance as a function of the SOC of the battery cell BC is sufficiently large in the voltage plateau range (Z_{A} ~ Z_{B}). For reference, the SOC-negative electrode resistance curve 400 may be a result (for example, a polynomial) of applying a curve fitting logic to a plurality of data points created by repeating the process of measuring the SOC and the negative electrode resistance of a plurality of test cells having the same specification as the battery cell BC.

Accordingly, while it is estimated that the SOC of the battery cell BC is located in the voltage plateau range (Z_{A} ~ Z_{B}), the SOC of the battery cell BC may be estimated with high accuracy by using the SOC-negative electrode resistance curve 400 singly, or a combination of the SOC-OCV curve 300 and the SOC-negative electrode resistance curve 400, instead of the SOC-OCV curve 300.

Referring to FIG. 5, the memory 140 stores third relationship data including at least one of an SOH-negative electrode resistance curve 510 or an SOH-negative electrode resistance curve 520 of the battery cell BC.

When a plurality of temperature ranges is predefined, the memory 140 may record the third relationship data prepared individually for the plurality of temperature ranges. The control unit 130 may acquire third relationship data mapped to the temperature value (measured cell temperature) of the battery cell BC among the plurality of temperature ranges from the memory 140, and use it to estimate the SOH.

The SOH-negative electrode resistance curve 510 shown in FIG. 5 exemplarily represents a relationship between the SOH and the negative electrode resistance in the fully discharged state (for example, SOC 0%) of the battery cell BC. Additionally, the SOH-negative electrode resistance curve 520 exemplarily represents a relationship between the SOH and the negative electrode resistance in the fully charged state (for example, SOC 100%) of the battery cell BC. Even though the SOH of the battery cell BC is equal to a specific value, as the SOC of the battery cell BC increases, the negative electrode resistance of the battery cell BC gradually decreases as described above, and also as can be seen from the two curves 510, 520 in FIG. 5.

The control unit 130 may determine the SOH of the battery cell BC by executing at least one of a first SOH estimation logic or a second SOH estimation logic.

The first SOH estimation logic may include any one of a variety of known SOH estimation logics or a combination of two or more. As an example, the control unit 130 may calculate the current maximum capacity of the battery cell BC by dividing the cumulative amount of current over a specific period of time or a certain period of time by a change in SOC over the same period of time. Subsequently, the control unit 130 may determine the estimated SOH from a percentage of a value obtained by dividing the maximum capacity of the battery cell BC by the design capacity (maximum capacity at BOL) of the battery cell BC. The first estimated SOH refers to the estimated SOH by executing the first SOH estimation logic.

When the battery cell BC is in fully discharged or charged state, the control unit 130 may estimate the SOH of the battery cell BC from the third relationship data based on the measured cell temperature and the measured negative electrode resistance of the battery cell BC by executing the second SOH estimation logic. That is, the second SOH estimation logic may search for the SOH mapped to each of the measured cell temperature and the measured negative electrode resistance of the battery cell BC from the third relationship data. The curve 510 of the third relationship data may be used when the battery cell BC is in fully discharged state, and the curve 520 of the third relationship data may be used when the battery cell BC is in fully charged state. The second SOH refers to the estimated SOH by executing the second SOH estimation logic.

When the battery cell BC is under load, the control unit 130 may determine (estimate) the OCV of the battery cell BC based on each of the measured cell voltage, the measured cell current and/or the measured cell temperature collected from the sensing unit 110. As an example, according to the Ohm's law, the estimated OCV of the battery cell BC may be calculated by subtracting the voltage value corresponding to the multiplication of the current value of the battery cell BC by the internal resistance of the battery cell BC from the voltage value of the battery cell BC. The control unit 130 may determine the internal resistance of the battery cell BC based on the ratio between the change in voltage of the battery cell BC at each set time and the change in current according to the Ohm' law. Alternatively, the internal resistance of the battery cell BC may be determined from the internal resistance map defining the relationship between SOC, temperature and internal resistance of the battery cell BC.

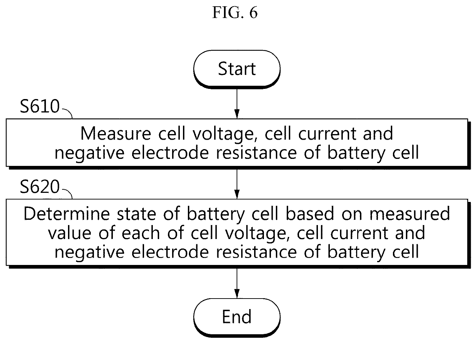

FIG. 6 is a flowchart exemplarily showing a battery management method according to a first embodiment of the present disclosure. When the battery cell BC is being charged/discharged or the resting time during which the battery cell BC is maintained at rest is less than a predetermined stabilization time, the method of FIG. 6 may be periodically performed by the battery management system 100 repeatedly at each set time. For reference, when the resting time is not sufficiently long, even though the battery cell BC is at rest, there may be an innegligible difference between the measured cell voltage of the battery cell BC detected by the voltage sensor 111 and the actual OCV of the battery cell BC.

Referring to FIGS. 1 to 6, in the step S610, the control unit 130 measures the cell voltage, the cell current and the negative electrode resistance of the battery cell BC using the sensing unit 110. That is, the control unit 130 may collect a sensing signal indicating the measured value of each of the cell voltage, the cell current and the negative electrode resistance of the battery cell BC from the sensing unit 110. In this instance, the control unit 130 may additionally collect the measured cell temperature of the battery cell BC.

In the step S620, the control unit 130 determines the electrical state of the battery cell BC based on the measured value of each of the cell voltage, the cell current and the negative electrode resistance of the battery cell BC. The electrical state includes SOC, and may further include SOH.

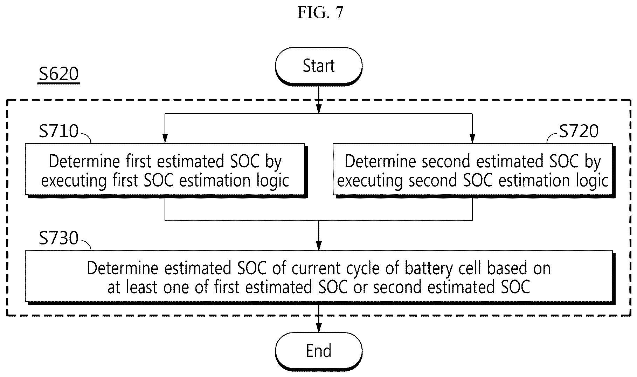

FIG. 7 is a flowchart exemplarily showing the subroutines of the step S620 in FIG. 6.

Referring to FIGS. 1 to 7, in the step S710, the control unit 130 determines a first estimated SOC based on each of the measured cell voltage and the measured cell current by executing a first SOC estimation logic.

The first SOC estimation logic may include any one of known SOC estimation logics (for example, OCV map, ampere counting (current integration), Kalman filtering) or a combination of two or more.

When executing the first SOC estimation logic, the control unit 130 may determine an estimated OCV of the battery cell BC based on the measured value of the cell parameter (at least one of the cell voltage, the cell current or the cell temperature) acquired from the sensing unit 110, and determine an SOC value associated with the estimated OCV among the SOC values recorded in the first relationship data as the first estimated SOC.

The first SOC estimation logic may be prepared for the control unit 130 to determine the estimated OCV by subtracting the voltage value by the internal resistance from the voltage value (measured cell voltage) indicating the OCV of the battery cell BC while the estimated SOC of the battery cell BC is outside of the voltage plateau range (Z_{A} ~ Z_{B}).

While the estimated SOC of the battery cell BC is inside of the voltage plateau range (Z_{A} ~ Z_{B}), the first SOC estimation logic may be prepared to determine the first estimated SOC to be equal to a value obtained by adding a change in SOC corresponding to the cumulative amount of current calculated while the estimated SOC of the battery cell BC resides in the voltage plateau range (Z_{A} ~ Z_{B}) to the past estimated SOC calculated immediately before the estimated SOC enters the voltage plateau range (Z_{A} ~ Z_{B}).

In the step S720, the control unit 130 determines a second estimated SOC based on the measured negative electrode resistance by executing a second SOC estimation logic. When executing the second SOC estimation logic, a series of procedures of determining, as the second estimated SOC, an SOC value associated with the measured negative electrode resistance collected in the step S710 among the negative electrode resistance values stored in the second relationship data may be performed.

In the step S730, the control unit 130 determines the estimated SOC of the current cycle of the battery cell based on at least one of the first estimated SOC or the second estimated SOC.

The control unit 130 records the estimated SOC in the memory 140 each time the step S730 is performed, and accordingly the memory 140 generates a change history (time series) of the estimated SOC. The estimated SOC of the current cycle determined in the step S730 becomes the estimated SOC of the previous cycle when the method according to FIG. 7 is performed again in the next cycle.

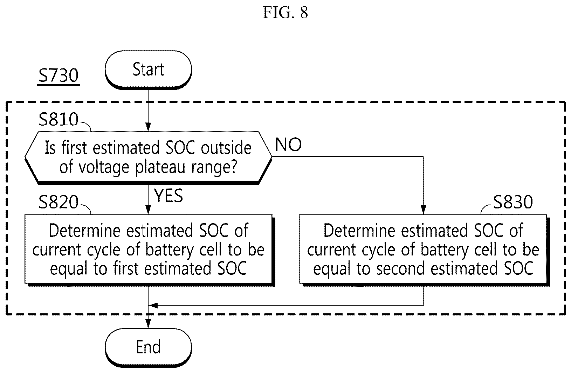

FIG. 8 is a flowchart schematically showing an example of the subroutines of the step S730 in FIG. 7.

Referring to FIGS. 1 to 8, in the step S810, the control unit 130 determines whether the first estimated SOC determined in the step S710 is outside of the voltage plateau range (Z_{A} ~ Z_{B}). That is, whether the first estimated SOC is less than the start SOC (Z_{A}) or more than the end SOC (Z_{B}) is determined in the step S810. When a value of the step S810 is "YES", the step S820 is performed. The value of the step S810 being "NO" represents that the first estimated SOC is inside of the voltage plateau range Z_{A} ~ Z_{B}. When the value of the step S810 is "NO", the step S830 is performed.

In the step S820, the control unit 130 determines the estimated SOC of the current cycle of the battery cell BC to be equal to the first estimated SOC.

In the step S830, the control unit 130 determines the estimated SOC of the current cycle of the battery cell BC to be equal to the second estimated SOC.

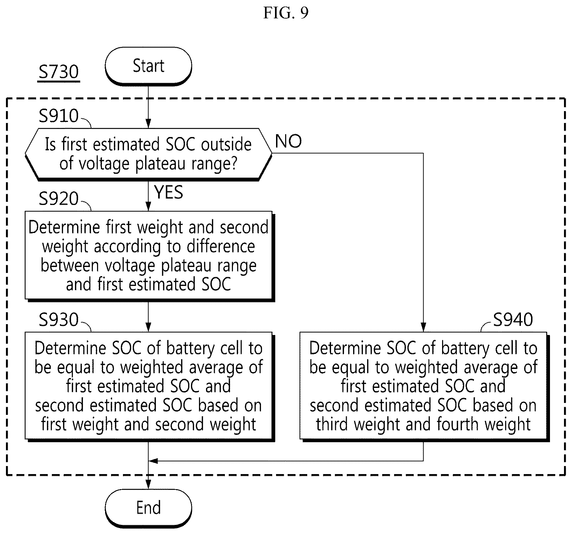

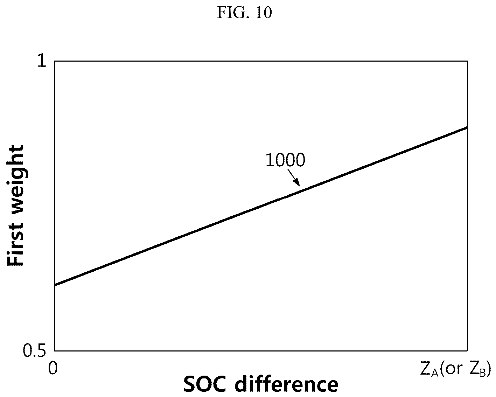

FIG. 9 is a flowchart schematically showing another example of the subroutines of the step S730 in FIG. 7, and FIG. 10 shows an example of a weight map that may be used when performing the method of FIG. 9.

Referring to FIGS. 1 to 7, 9 and 10, in the step S910, the control unit 130 determines whether the first estimated SOC determined in the step S610 is outside of the voltage plateau range (Z_{A} ~ Z_{B}). When a value of the step S910 is "YES", the step S920 is performed. When the value of the step S910 is "NO", the step S940 is performed.

In the step S920, the control unit 130 determines a first weight associated with the first estimated SOC and a second weight associated with the second estimated SOC according to an SOC difference between the voltage plateau range (Z_{A} ~ Z_{B}) and the first estimated SOC.

When the first estimated SOC is less than the start SOC (Z_{A}), the SOC difference between the voltage plateau range (Z_{A} ~ Z_{B}) and the first estimated SOC may be determined to be equal to a difference between the first estimated SOC and the start SOC(Z_{A}).

When the first estimated SOC is more than the end SOC(Z_{B}), the SOC difference between the voltage plateau range (Z_{A} ~ Z_{B}) and the first estimated SOC may be determined to be equal to a difference between the first estimated SOC and the end SOC(Z_{B}).

The first weight may have a predetermined positive correlation to the SOC difference between the voltage plateau range (Z_{A} ~ Z_{B}) and the first estimated SOC. The second weight may have a predetermined negative correlation to the SOC difference between the voltage plateau range (Z_{A} ~ Z_{B}) and the first estimated SOC. The sum of the first weight and the second weight may be a constant (for example, 1), and accordingly when any one of the first weight and the second weight is determined, the other one may be automatically determined. The first weight may be equal to or larger than the second weight.

FIG. 10 shows the weight map 1000 recording the relationship between the first weight and the SOC difference. The weight map 1000 may be prestored in the memory 140.

The SOC difference close to 0 refers to the first estimated SOC close to the voltage plateau range (Z_{A} ~ Z_{B}). On the contrary, the SOC difference close to the lower limit (Z_{A}) or the upper limit (Z_{B}) refers to the first estimated SOC far away from the voltage plateau range (Z_{A} ~ Z_{B}).

When the first estimated SOC is less than the lower limit (Z_{A}), the start SOC(Z_{A}) may be set to the maximum value of the horizontal axis in FIG. 10, and when the first estimated SOC is more than the upper limit (Z_{B}), the end SOC(Z_{B}) may be set to the maximum value of the horizontal axis in FIG. 10.

In the step S930, the control unit 130 determines the estimated SOC of the current cycle of the battery cell BC to be equal to a weighted average of the first estimated SOC and the second estimated SOC based on the first weight and the second weight.

For example, in the case where the first weight = 0.8, the second weight = 0.2, the first estimated SOC = 80%, the second estimated SOC = 81%, the weighted average = (the first estimated SOC X the first weight) + (the second estimated SOC X the second weight)= (80% X 0.8) + (81% X 0.2) = 80.2%.

In the step S940, the control unit 130 determines the estimated SOC of the current cycle of the battery cell BC to be equal to the weighted average of the first estimated SOC and the second estimated SOC based on a third weight associated with the first estimated SOC and a fourth weight associated with the second estimated SOC.

As opposed to the first weight and the second weight, the third weight and the fourth weight may be a prestored constant in the memory 140. The fourth weight may be equal to or larger than the third weight, and the sum of the third weight and the fourth weight may be equal to the sum of the first weight and the second weight. For example, in the case where the third weight = 0.3, the fourth weight = 0.7, the first estimated SOC = 60%, the second estimated SOC = 61%, the weighted average = (the first estimated SOC × the third weight) + (the second estimated SOC × the fourth weight)= (60% × 0.3) + (61% × 0.7) = 18% + 42.7% = 60.7%. The third weight may be equal to or smaller than the minimum value that may be set as the first weight. The fourth weight may be equal to or larger than the maximum value that may be set as the second weight.

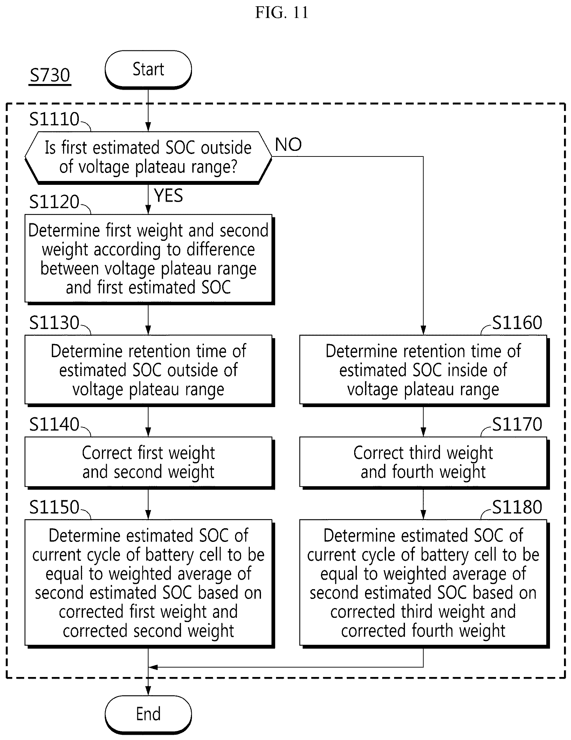

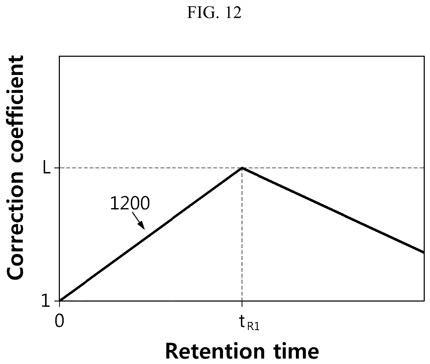

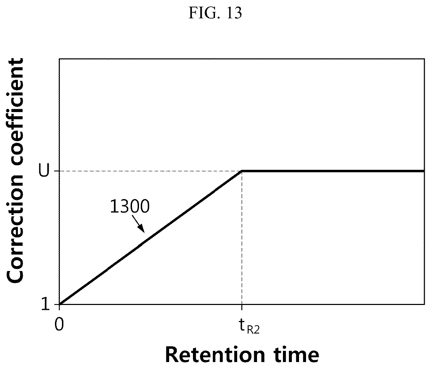

FIG. 11 is a flowchart schematically showing another example of the subroutines of the step S730 in FIG. 7, FIG. 12 shows an example of a first correction coefficient map used to correct the first weight, and FIG. 13 shows an example of a second correction coefficient map used to correct the fourth weight.

Referring to FIGS. 1 to 7 and 11 to 13, in the step S1110, the control unit 130 determines whether the first estimated SOC determined in the step S610 is outside of the voltage plateau range (Z_{A} ~ Z_{B}). When a value of the step S1110 is "YES", the step S1120 is performed. When the value of the step S1110 is "NO", the step S1160 is performed.

In the step S1120, the control unit 130 determines the first weight associated with the first estimated SOC and the second weight associated with the second estimated SOC according to the SOC difference between the voltage plateau range (Z_{A} ~ Z_{B}) and the first estimated SOC.

In the step S1130, the control unit 130 determines the retention time of the estimated SOC outside of the voltage plateau range (Z_{A} ~ Z_{B}) based on time series of the estimated SOC. That is, how long the estimated SOC has stayed outside of the voltage plateau range (Z_{A} ~ Z_{B}) from the latest time the estimated SOC got out of the voltage plateau range (Z_{A} ~ Z_{B}) is determined.

In the step S1140, the control unit 130 corrects the first weight and the second weight according to the retention time determined in the step S1130. For example, after correcting any one of the first weight and the second weight, a corrected value of the other weight may be determined by subtracting the corrected weight from a predetermined constant (for example, 1).

The first correction coefficient map 1200 shown in FIG. 12 may be prestored in the memory 140, and used to correct the first weight.

According to the first correction coefficient map 1200, until before the retention time of the estimated SOC outside of the voltage plateau range (Z_{A} ~ Z_{B}) reaches a predetermined reference time t_{R1}, the correction coefficient for the first weight may have a positive correlation to the retention time. After the retention time reaches the reference time t_{R1}, the correction coefficient for the first weight may have a negative correlation to the retention time. The minimum of the correction coefficient for the first weight may be 1. The reference value L may be larger than 1, and may be a preset value to prevent the excessive increase of the corrected first weight.

As the retention time outside of the voltage plateau range (Z_{A} ~ Z_{B}) increases, accumulation of current integration errors occurs, resulting in a gradual decline in accuracy of the first estimated SOC determined by the first SOC estimation logic. Accordingly, when the reference time t_{R1} is appropriately set through pre-testing or simulation, it may be possible to prevent the decline in SOC estimation accuracy due to too long retention time of the SOC of the battery cell BC outside the voltage plateau range (Z_{A} ~ Z_{B}).

In relation to this, although FIG. 12 shows a linear change in the correction coefficient for the first weight before and after the reference time t_{R1}, it should be simply understood as an example.

The corrected first weight may be equal to the multiplication of the correction coefficient determined in the first correction coefficient map 1200 by the first weight. When the corrected first weight is determined, the control unit 130 may calculate the corrected second weight such that the sum of the corrected first weight and the corrected second weight is equal to a predetermined value (for example, 1).

In the step S1150, the control unit 130 determines the estimated SOC of the current cycle of the battery cell BC to be equal to the weighted average of the first estimated SOC and the second estimated SOC based on the corrected first weight and the corrected second weight. For example, in the case where the corrected first weight = 0.81, the corrected second weight = 0.19, the first estimated SOC = 80%, the second estimated SOC = 81%, the weighted average = (the first estimated SOC × the corrected first weight) + (the second estimated SOC × the corrected second weight)= (80% × 0.81) + (81% × 0.19) = 20.25% + 4.94% = 80.19%.

That is, the first estimated SOC and the second estimated SOC are, respectively, 80% and 81% equal to the example described above with reference to FIG. 9, but the corrected first weight determined according to the time length of the retention time is more than the original first weight and the corrected second weight is less than the original second weight, so it can be seen that the SOC determined in the step S1150 is shifted from 80.2% to 80.19% that is closer to the first estimated SOC.

In the step S1160, the control unit 130 determines the retention time of the estimated SOC inside of the voltage plateau range (Z_{A} ~ Z_{B}) based on time series of the estimated SOC. That is, how long the estimated SOC has stayed in the voltage plateau range (Z_{A} ~ Z_{B}) from the latest time the estimated SOC entered the voltage plateau range (Z_{A} ~ Z_{B}) is determined.

In the step S1170, the control unit 130 corrects the third weight and the fourth weight according to the retention time determined in the step S1160.

FIG. 13 shows the second correction coefficient map 1300 recording the relationship between the correction coefficient and the retention time used to correct the fourth weight. The second correction coefficient map 1300 may be stored in the memory 140.

Referring to FIG. 13, until before the retention time reaches a predetermined reference time t_{R2}, the correction coefficient may have a positive correlation to the retention time, and while the retention time is equal to or more than the reference time t_{R2}, the correction coefficient may be maintained at the reference value U. The reference value U may be larger than 1. The reference value U may be a preset value to prevent the excessive increase of the corrected fourth weight.

In relation to this, although FIG. 13 shows a linear change in the correction coefficient for the fourth weight in the time range less than the reference time t_{R2}, it should be simply understood as an example.

The corrected fourth weight may be equal to the multiplication of the correction coefficient determined in the second correction coefficient map 1300 by the fourth weight. When the corrected fourth weight is determined, the control unit 130 may calculate the corrected third weight such that the sum of the corrected third weight and the corrected fourth weight is equal to a predetermined value (for example, 1).

In the step S1180, the control unit 130 determines the estimated SOC of the current cycle of the battery cell BC to be equal to the weighted average of the first estimated SOC and the second estimated SOC based on the corrected third weight and the corrected fourth weight. For example, in the case where the corrected third weight = 0.25, the corrected fourth weight = 0.75, the first estimated SOC = 60%, the second estimated SOC = 61%, the weighted average = (the first estimated SOC × the corrected third weight) + (the second estimated SOC × the corrected fourth weight) = 60.75%.

That is, the first estimated SOC and the second estimated SOC are, respectively, 60% and 61% equal to the example in FIG. 9, but the corrected third weight determined according to the retention time is less than the original third weight and the corrected fourth weight is more than the original fourth weight, so it can be seen that the SOC determined in the step S1180 is shifted from 60.7% to 60.75% that is closer to the second estimated SOC.

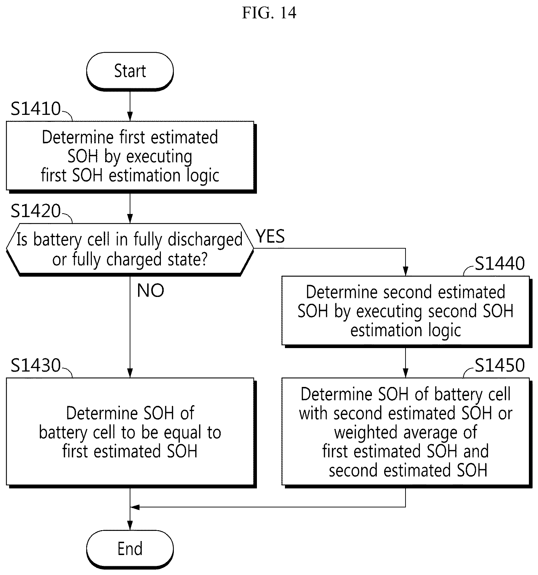

FIG. 14 is a flowchart exemplarily showing the battery management method according to a second embodiment of the present disclosure. The method according to FIG. 14 may be performed after the estimated SOC of the battery cell BC is determined by the method according to FIG. 7.

Referring to FIG. 14, in the step S1410, the control unit 130 determines the first estimated SOH by executing the first SOH estimation logic.

In the step S1420, the control unit 130 determines whether the battery cell BC is in fully discharged or fully charged state. As an example, the estimated SOC of the current cycle determined in the step S730 being 0% indicates that the battery cell BC is in fully discharge state. As another example, the estimated SOC of the current cycle determined in the step S730 being 100% indicates that the battery cell BC is in fully charged state.

When a value of the step S1420 is "YES", the step S1430 is performed. The value of the step S1420 being "NO" represents that the battery cell BC is neither in fully discharged state or fully charged state. When the value of the step S1420 is "NO", the step S1440 is performed.

In the step S1430, the SOH of the battery cell BC is determined to be equal to the first estimated SOH.

In the step S1440, the control unit 130 determines the second estimated SOH by executing the second SOH estimation logic. When the fully discharged state is determined in the step S1420, the curve 510 is used to determine the second estimated SOH. In contrast, when the fully charged state is determined in the step S1420, the curve 520 is used to determine the second estimated SOH.

In the step S1450, the control unit 130 determines the current estimated SOH of the battery cell BC with the second estimated SOH or the weighted average of the first estimated SOH and the second estimated SOH. The weighted average of the first estimated SOH and the second estimated SOH may be equal to the sum of a value obtained by multiplying the first estimated SOH by a predetermined weight (a fifth weight) and a value obtained by multiplying the second estimated SOH by a predetermined weight (a sixth weight). The sum of the fifth weight and the sixth weight may be a constant (for example, 1). Each of the fifth weight and the sixth weight may be preset.

The embodiments of the present disclosure as described above are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

## Claims

1. A battery management system comprising:
a sensing unit configured to measure a cell voltage, a cell current, and a negative electrode resistance of a battery cell; and
a control unit configured to determine a state of the battery cell based on a measured value of each of the cell voltage, the cell current and the negative electrode resistance.

2. The battery management system according to claim 1,
wherein the control unit is configured to:
determine a first estimated state of charge (SOC) based on the measured value of each of the cell voltage and the cell current by executing a first SOC estimation logic,
determine a second estimated SOC based on the measured value of the negative electrode resistance by executing a second SOC estimation logic, and
determine an estimated SOC of a current cycle of the battery cell based on at least one of the first estimated SOC or the second estimated SOC.

3. The battery management system according to claim 2,
wherein the control unit is configured to determine the estimated SOC of the current cycle of the battery cell to be equal to any one of the first estimated SOC and the second estimated SOC or a weighted average of the first estimated SOC and the second estimated SOC according to a result of comparing the first estimated SOC with a voltage plateau range.

4. The battery management system according to claim 3,
wherein the control unit is configured to:
determine the estimated SOC of the current cycle of the battery cell to be equal to the first estimated SOC when the first estimated SOC is outside of the voltage plateau range.

5. The battery management system according to claim 3,
wherein the control unit is configured to:
determine the estimated SOC of the current cycle of the battery cell to be equal to the second estimated SOC when the first estimated SOC is inside of the voltage plateau range.

6. The battery management system according to claim 3,
wherein the control unit is configured to:
determine a first weight associated with the first SOC estimation logic and a second weight associated with the second SOC estimation logic according to a difference between the voltage plateau range and the first estimated SOC when the first estimated SOC is outside of the voltage plateau range, and
determine the estimated SOC of the current cycle of the battery cell to be equal to the weighted average of the first estimated SOC and the second estimated SOC based on the first weight and the second weight.

7. The battery management system according to claim 6,
wherein the first weight has a predetermined positive correlation to the difference between the voltage plateau range and the first estimated SOC, and
wherein the second weight has a predetermined negative correlation to the difference between the voltage plateau range and the first estimated SOC.

8. The battery management system according to claim 3,
wherein the control unit is configured to:
determine the estimated SOC of the current cycle of the battery cell to be equal to the weighted average of the first estimated SOC and the second estimated SOC based on a third weight and a fourth weight when the first estimated SOC is inside of the voltage plateau range.

9. The battery management system according to claim 3,
wherein the control unit is configured to:
determine a first weight associated with the first SOC estimation logic and a second weight associated with the second SOC estimation logic according to a difference between the voltage plateau range and the first estimated SOC when the first estimated SOC is outside of the voltage plateau range,
correct the first weight and the second weight according to a retention time of the SOC within the voltage plateau range, and
determine the estimated SOC of the current cycle of the battery cell to be equal to the weighted average of the first estimated SOC and the second estimated SOC based on the corrected first weight and the corrected second weight.

10. The battery management system according to claim 2,
wherein the control unit is configured to:
determine a current estimated SOH of the battery cell based on the measured value of each of the negative electrode resistance and a cell temperature of the battery cell when the estimated SOC of the current cycle indicates a fully discharged or fully charged state.

11. A battery pack comprising the battery management system according to any one of claims 1 to 10.

12. An electric vehicle comprising the battery pack according to claim 11.

13. A battery management method comprising the steps of:
measuring a cell voltage, a cell current, and a negative electrode resistance of a battery cell; and
determining a state of the battery cell based on a measured value of each of the cell voltage, the cell current and the negative electrode resistance.

14. The battery management method according to claim 13,
wherein the step of determining an electrical state of the battery cell comprises the steps of:
determining a first estimated state of charge (SOC) based on the measured value of each of the cell voltage and the cell current by executing a first SOC estimation logic;
determining a second estimated SOC based on the measured value of the negative electrode resistance by executing a second SOC estimation logic; and
determining an estimated SOC of a current cycle of the battery cell based on at least one of the first estimated SOC or the second estimated SOC.

15. The battery management method according to claim 14,
wherein the step of determining the estimated SOC of the current cycle of the battery cell comprises the step of:
determining the estimated SOC of the current cycle of the battery cell to be equal to any one of the first estimated SOC and the second estimated SOC or a weighted average of the first estimated SOC and the second estimated SOC according to a result of comparing the first estimated SOC with a voltage plateau range.
